# EUROPÄISCHE PATENTSCHRIFT

(11) **EP 4 228 935 B1**
(45) Veröffentlichungstag und Bekanntmachung des Hinweises auf die Patenterteilung: **30.09.2026**
(21) Anmeldenummer: 21790384.8
(22) Anmeldetag: 29.09.2021
(51) Int. Cl.: B60R 25/24, E05B 81/78, H03K 17/96, G07C 9/00, H03K 17/955

(54) **SYSTEM ZUR DETEKTION EINER AKTIVIERUNGSHANDLUNG IN EINEM AKTIVIERUNGSBEREICH FÜR EIN FAHRZEUG**
SYSTEM FOR THE DETECTION OF AN ACTIVATION ACTION IN AN ACTIVATION RANGE FOR A VEHICLE
SYSTÈME DE DÉTECTION D'UNE ACTION D'ACTIVATION DANS UNE PLAGE D'ACTIVATION D'UN VÉHICULE

(30) Priorität: 19.10.2020 DE 102020127438
(43) Veröffentlichungstag der Anmeldung: 23.08.2023
(73) Patentinhaber: Huf Hülsbeck & Fürst GmbH & Co. KG, 42551 Velbert (DE)
(72) Erfinder: SIEG, Berthold, 46240 Bottrop (DE)
(74) Vertreter: Bals & Vogel Patentanwälte PartGmbB
(86) Internationale Anmeldenummer: PCT/EP2021/076773
(87) Internationale Veröffentlichungsnummer: WO 2022/083991

(56) Entgegenhaltungen:
- EP-A1- 3 651 126
- WO-A1-2017/144346
- DE-A1- 102014 107 559
- DE-A1- 102019 104 098
- DE-B3- 102018 221 743

## Beschreibung

Die vorliegende Erfindung betrifft ein System zur Detektion einer Aktivierungshandlung in einem Aktivierungsbereich für ein Fahrzeug. Ferner bezieht sich die Erfindung auf ein Verfahren zur Detektion einer Aktivierungshandlung in einem Aktivierungsbereich für ein Fahrzeug.

Es ist aus dem Stand der Technik bekannt, dass kapazitive Sensoren bei Fahrzeugen zur Erfassung einer Annäherung verwendet werden können. Bspw. kann die Annäherung eine Aktivierungshandlung sein, mit welcher ein Benutzer eine Funktion am Fahrzeug aktiviert. Bei sicherheitsrelevanten Funktionen, wie die Entriegelung des Fahrzeuges, ist es üblicherweise vorgesehen, dass die Aktivierung der Funktion eine erfolgreiche Authentifizierung mittels einer Kommunikation des Fahrzeuges mit einem mobilen Gerät voraussetzt. Die Detektion der Aktivierungshandlung kann dann zunächst zur Initiierung der Authentifizierung über die Kommunikation führen, um dann bei erfolgreicher Authentifizierung die Funktion zu aktivieren.

Das Dokument DE 10 2018 221743 offenbart ein System zur Detektion einer Aktivierungshandlung in einem Aktivierungsbereich für ein Fahrzeug, aufweisend eine Sensoranordnung zur kapazitiven Erfassung einer Annäherung zumindest teilweise im Aktivierungsbereich, um die Aktivierungshandlung zu detektieren und eine Kommunikationsanordnung zur Durchführung einer Kommunikation zumindest teilweise im Aktivierungsbereich.

Nachteilhaft bei bekannten Lösungen ist, dass im Rahmen der Kommunikation das hierfür ggf. notwendige Annähern und auch darüberhinausgehende Bewegungen zu Fehldetektionen der Aktivierungshandlungen führen können. Insbesondere bei einer Nahfeldkommunikation kann das notwendige Einbringen eines mobilen Geräts zur Kommunikation in den Kommunikationsbereich mit anschließenden weiteren Bewegungen fälschlicherweise als Aktivierungshandlung interpretiert werden.

Es ist daher eine Aufgabe der vorliegenden Erfindung, die voranstehend beschriebenen Nachteile zumindest teilweise zu beheben. Insbesondere ist es Aufgabe der vorliegenden Erfindung, eine verbesserte Lösung zur Detektion einer Aktivierungshandlung in einem Aktivierungsbereich für ein Fahrzeug vorzuschlagen.

Die voranstehende Aufgabe wird gelöst durch ein System mit den Merkmalen des unabhängigen Systemanspruchs und durch ein Verfahren mit den Merkmalen des unabhängigen Verfahrensanspruchs. Weitere Merkmale und Details der Erfindung ergeben sich aus den jeweiligen Unteransprüchen, der Beschreibung und den Zeichnungen. Dabei gelten Merkmale und Details, die im Zusammenhang mit dem erfindungsgemäßen System beschrieben sind, selbstverständlich auch im Zusammenhang mit dem erfindungsgemäßen Verfahren, und jeweils umgekehrt, so dass bezüglich der Offenbarung zu den einzelnen Erfindungsaspekten stets wechselseitig Bezug genommen wird bzw. werden kann.

Die Aufgabe wird insbesondere gelöst durch ein System zur Detektion einer Aktivierungshandlung in einem Aktivierungsbereich für ein Fahrzeug. Hierbei ist insbesondere vorgesehen, dass das System die folgenden Komponenten umfasst:
- eine (insbesondere zumindest teilweise elektronische) Sensoranordnung zur kapazitiven Erfassung einer Annäherung, insbesondere an das Fahrzeug, z. B. eines Aktivierungsmittels wie einer Hand, zumindest teilweise im Aktivierungsbereich (d. h. in zumindest einem Teilbereich des Aktivierungsbereichs, vorzugsweise einem Erfassungsbereich), um die Aktivierungshandlung zu detektieren, und vorzugsweise, um bei der (erfolgreichen) Detektion der Aktivierungshandlung eine Kommunikation zu initiieren,
- eine (insbesondere elektronische) Kommunikationsanordnung zur Durchführung einer bzw. der Kommunikation, insbesondere für das Fahrzeug, zumindest teilweise im Aktivierungsbereich (d. h. in zumindest einem Teilbereich des Aktivierungsbereichs, vorzugsweise einem Kommunikationsbereich),
- eine (insbesondere elektronische) Überwachungsanordnung zur Initiierung einer Unterbrechung und/oder Neuinitialisierung (auch als Reinitialisierung bezeichnet) der kapazitiven Erfassung in Abhängigkeit von der Kommunikation.

In anderen Worten kann es vorgesehen sein, dass in Abhängigkeit von der Kommunikation, z. B. nach der Initiierung der Kommunikation und/oder nach erfolgreicher Authentifizierung durch die Kommunikation, die kapazitive Erfassung zunächst unterbrochen und/oder neuinitialisiert wird. Damit wird der Vorteil erzielt, dass im Zusammenhang mit der Kommunikation stehende Bewegungen, wie eine nach der Aktivierungshandlung bzw. dem Einbringen eines mobilen Geräts erfolgte weitere Bewegung, nicht fälschlicherweise als weitere Aktivierungshandlung detektiert werden kann und somit erneut zur Detektion führt. Nach dem Einbringen eines mobilen Geräts zur Kommunikation durch ein Aktivierungsmittel erfolgt bspw. nicht sofort das Entfernen des mobilen Geräts, sondern ggf. noch eine weitere Annäherung des Aktivierungsmittels, welche dann mit einer Aktivierungshandlung verwechselt werden könnte. Bspw. dient die Detektion der Aktivierungshandlung dazu, um bei erfolgreicher Detektion die Kommunikation zu initiieren und/oder bei erfolgreicher Authentifizierung (durch die Kommunikation) eine Fahrzeugfunktion zu aktivieren. Entsprechend kann eine Fehldetektion auch das erneute Aktivieren der Fahrzeugfunktion zur Folge haben. Die Fahrzeugfunktion ist z. B. ein Umschalten zwischen einer Ver- und Entriegelung des Fahrzeuges. Durch die erfindungsgemäße Lösung können daher auch die Zuverlässigkeit und Sicherheit bei dem Fahrzeug gesteigert werden.

Die Überwachungsanordnung kann Teil der Sensoranordnung und/oder der Kommunikationsanordnung sein und/oder zumindest teilweise auch separat davon vorgesehen sein, und entsprechend mit der Sensoranordnung und ggf. auch der Kommunikationsanordnung verschaltet sein.

Es kann vorgesehen sein, dass die Sensoranordnung zumindest eine Sensorelektrode aufweist, um mit einer Umgebung des Fahrzeuges (im Aktivierungsbereich) und ggf. mit der Fahrzeugkarossiere als Gegenelektrode eine veränderliche Kapazität bereitzustellen. Eine Annäherung im Aktivierungsbereich kann dann entsprechend eine Veränderung der Kapazität zur Folge haben. Die Kapazitätsveränderungen können z. B. durch eine Verarbeitungsvorrichtung der Sensoranordnung ausgewertet werden, z. B. mittels Ladungsübertragungen zur Sensorelektrode. Die übertragenen Ladungen werden hierzu z. B. wiederholt durch einen Integrator kumuliert und die daraus resultierenden Werte als Erfassungswerte zwischengespeichert. Ein ansteigender Verlauf der Erfassungswerte kann entsprechend auf eine Annäherung hinweisen, bspw. dann, wenn der Verlauf einen Schwellenwert übersteigt. Gleichwohl kann es vorgesehen sein, dass nach der Annäherung zur Kommunikation und/oder einer vorigen Aktivierungshandlung die Erfassungswerte des Verlaufs bereits angestiegen sind, und somit die Differenz zum Schwellenwert geringer ist. Nach der Kommunikation bzw. der daraus resultierenden Authentifizierung und/oder Funktionsaktivierung kann dann eine geringfügige weitere Annäherung ausreichend sein, um fälscherweise (erneut) die Aktivierungshandlung zu detektieren. Hierbei kann eine Erfindungsidee sein, dass in Abhängigkeit von der Kommunikation, z. B. nach einer erfolgreichen Nahfeldkommunikation, zunächst die kapazitive Erfassung ausgesetzt wird. Auf diese Weise kann nach der Authentifizierung über die Kommunikation das Wegbewegen des Aktivierungsmittels nicht als weitere Aktivierungshandlung erkannt werden.

Es ist vorteilhaft, wenn neben der Unterbrechung, also einem Time-Out der kapazitiven Erfassung, auch eine Neuinitialisierung eingesetzt wird. Die Neuinitialisierung kann die Wirkung haben, dass vergangene zwischengespeicherte Erfassungswerte der kapazitiven Erfassung gelöscht werden, und damit das angenäherte Aktivierungsmittel keinen Sprung dieser Messwerte bewirken kann, welche sich als Fehldetektion auswirken könnte. Es handelt sich hierbei insbesondere um eine Art Neukalibrierung.

Der Aktivierungsbereich kann, insbesondere ausschließlich, einen Erfassungsbereich der Sensoranordnung und einen Kommunikationsbereich der Kommunikationsanordnung aufweisen. Der Erfassungsbereich und der Kommunikationsbereich können überlappen, können aber auch beabstandet voneinander sein. Entscheidend kann sein, dass die Aktivierungshandlung den Rückschluss ermöglicht, dass ein mobiles Gerät in den Kommunikationsbereich gebracht wird oder wurde. Bspw. ist die Aktivierungshandlung daher eine Annäherung eines Aktivierungsmittels wie bspw. einer Hand, welche das mobile Gerät hält und in den Kommunikationsbereich einbringt.

Vorteilhaft ist es zudem, wenn das Fahrzeug als ein Kraftfahrzeug, insbesondere als ein Hybridfahrzeug oder als ein Elektrofahrzeug ausgebildet ist, vorzugsweise mit einem Hochvolt-Bordnetz und/oder einem Elektromotor. Außerdem kann es möglich sein, dass das Fahrzeug als ein Brennstoffzellenfahrzeug und/oder Personenkraftfahrzeug und/oder semiautonomes oder autonomes Fahrzeug ausgebildet ist. Vorteilhafterweise weist das Fahrzeug ein Sicherheitssystem auf, welches durch die Kommunikation mit einem mobilen Gerät, z. B. einem Identifikationsgeber (ID-Geber) oder Mobilfunkgerät oder Smartphone, eine Authentifizierung ermöglicht. In Abhängigkeit von der Kommunikation und/oder der Authentifizierung kann wenigstens eine Funktion des Fahrzeuges aktiviert werden. Falls hierzu die Authentifizierung des mobilen Geräts notwendig ist, kann es sich bei der Funktion um eine sicherheitsrelevante Funktion handeln, wie ein Entriegeln und/oder Verriegeln des Fahrzeuges oder eine Freigabe eines Motorstarts. Somit kann das Sicherheitssystem auch als ein passives Zugangssystem ausgebildet sein, welches ohne aktive manuelle Betätigung des mobilen Geräts die Authentifizierung und/oder die Aktivierung der Funktion bei Detektion der Annäherung des mobilen Geräts an das Fahrzeug initiiert. Hierzu wird bspw. ein Erfassungsbereich durch eine kapazitive Erfassung auf eine Aktivierungshandlung überwacht, um bei der Detektion der Aktivierungshandlung die Kommunikation und/oder Authentifizierung auszulösen, und/oder es wird wiederholt ein Wecksignal durch das Sicherheitssystem ausgesendet, welches durch den mobilen Gerät bei der Annäherung empfangen werden kann, und dann die Authentifizierung auslöst. Ferner kann die Funktion eine Aktivierung einer Fahrzeugbeleuchtung und/oder ein Betätigen (Öffnen und/oder Schließen) einer Klappe (z. B. Front- oder Heck- oder Seitenklappe bzw. -tür) betreffen. Bspw. wird automatisch bei der Detektion der Annäherung eine Fahrzeugbeleuchtung teilweise aktiviert und/oder bei der Detektion einer Geste wie der Aktivierungshandlung eines Benutzers die Klappe betätigt.

Vorteilhafterweise kann bei der Erfindung vorgesehen sein, dass die Kommunikationsanordnung als eine Nahfeld-Kommunikationsanordnung ausgebildet ist, um die Kommunikation in der Form einer Nahfeldkommunikation begrenzt auf zumindest einen Kommunikationsbereich des Aktivierungsbereichs durchzuführen. Die Nahfeldkommunikation ist z. B. als NFC (Near Field Communication) ausgebildet. Entsprechend kann die Kommunikationsanordnung eine NFC-Antenne aufweisen, um ein Kommunikationssignal zu empfangen und/oder zu erzeugen. Die Nahfeldkommunikation basiert z. B. darauf, dass ein magnetisches Wechselfeld erzeugt wird, um einen Strom bei dem mobilen Gerät zu erzeugen.

Es ist ferner denkbar, dass die Kommunikationsanordnung dazu ausgeführt ist, die Kommunikation mit einem mobilen Gerät dann initial durchzuführen, wenn das mobile Gerät in einen Kommunikationsbereich des Aktivierungsbereichs eingebracht wird, wobei die Annäherung bei der Aktivierungshandlung für das Einbringen des mobilen Geräts spezifisch sein kann. Die Annäherung kann dadurch für das Einbringen spezifisch sein, dass durch die Aktivierungshandlung zunächst die Annäherung des mobilen Geräts in den Aktivierungsbereich erfolgt bzw. erfolgen muss, bevor das mobile Gerät in Kommunikationsreichweite für die Kommunikation, insbesondere Nahfeldkommunikation, ist und somit die Kommunikation stattfinden kann. Allerdings kann es auch nach der Kommunikation ggf. zur weiteren Annäherung kommen, obwohl das mobile Gerät eigentlich aus dem Aktivierungsbereich entfernt werden müsste. Dies kann zur erneuten Detektion und damit Fehldetektion der Aktivierungshandlung führen, welche jedoch durch die Unterbrechung bzw. Neuinitialisierung verhindert werden kann.

Ferner kann das Einbringen ggf. als Aktivierungshandlung erkannt werden und zur Auslösung der Kommunikation führen, oder aber auch (insbesondere ein weiteres Einbringen nach erfolgreicher Detektion) zu einer Fehldetektion der Aktivierungshandlung führen. Entsprechend kann die Unterbrechung zeitlich so durchgeführt werden, dass das weitere Einbringen nicht mehr zur Detektion führen kann.

Vorteilhaft ist es zudem, wenn die Überwachungsanordnung dazu ausgeführt ist, in Abhängigkeit von der Unterbrechung, insbesondere nach und/oder bei und/oder vor der Unterbrechung und/oder vor einer Wiederaufnahme der kapazitiven Erfassung nach der Unterbrechung, die Neuinitialisierung bei der Sensoranordnung zu initiieren oder auszuführen. Damit kann verhindert werden, dass eine vorangegangene kapazitive Erfassung, also bspw. ein bereits zwischengespeicherter Verlauf der Erfassungswerte, dazu führt, dass bereits eine geringfügige Annäherung als Aktivierungshandlung detektiert wird. Bspw. wird die Detektion so durchgeführt, dass ein bestimmter Verlauf der Erfassungswerte vorliegen und/oder ein bestimmter Schwellenwert durch die Erfassungswerte überschritten werden muss, damit die Detektion erfolgreich ist. Wenn nach der Unterbrechung das Aktivierungsmittel sich bereits nahe an einer Sensorelektrode der Sensoranordnung befindet, kann eine weitere Bewegung des Aktivierungsmittels leicht zur Fehldetektion der Aktivierungshandlung führen. Die Neuinitialisierung kann erreichen, dass der vorangegangene Verlauf "vergessen" wird und/oder der Schwellenwert neu kalibriert wird.

Vorzugsweise kann vorgesehen sein, dass die Sensoranordnung eine Speichervorrichtung wie einen Datenspeicher aufweist, um einen zeitlichen Verlauf von Erfassungswerten der kapazitiven Erfassung für die Detektion der Aktivierungshandlung zu speichern, und insbesondere eine (elektronische) Verarbeitungsvorrichtung aufweist, um bei der Neuinitialisierung die Speicherung der Erfassungswerte aufzuheben, insbesondere die Erfassungswerte zu löschen. Damit kann eine Art Neukalibrierung der Sensoranordnung erfolgen.

Von weiterem Vorteil kann vorgesehen sein, dass die Sensoranordnung dazu ausgeführt ist, nach der Neuinitialisierung wiederholt die Erfassungen bis zur Unterbrechung durchzuführen, insbesondere, um wiederholt die Aktivierungshandlung zu detektieren. In anderen Worten kann nach der Neuinitialisierung zunächst ein Normalbetrieb durchgeführt werden, in welchem wiederholt ein Erfassungsbereich auf eine Annäherung überwacht wird. Hierzu werden bspw. wiederholt Ladungsübertragungen zu einer Sensorelektrode der Sensoranordnung durchgeführt und ausgewertet, um wenigstens einen Erfassungswert zu erhalten. Um einen Verlauf einer Annäherung zu erkennen, können zudem die Erfassungswerte in einer Speichervorrichtung für eine bestimmte Zeitdauer zwischengespeichert werden.

Beispielsweise kann es vorgesehen sein, dass die Sensoranordnung dazu ausgeführt ist, einen zeitlichen Verlauf von Erfassungswerten der kapazitiven Erfassung für die Detektion der Aktivierungshandlung bereitzustellen, wobei vorzugsweise eine (insbesondere elektronische) Verarbeitungsvorrichtung (wie ein Mikrocontroller) der Sensoranordnung dazu ausgeführt ist, zur Detektion der Aktivierungshandlung den bereitgestellten Verlauf auszuwerten, insbesondere nach einem Anstieg der Erfassungswerte die Erfassungswerte mit einem Schwellenwert zu vergleichen, und/oder bei der Neuinitialisierung den bereitgestellten Verlauf zurückzusetzen. Damit kann verhindert werden, dass vorangegangene und gespeicherte Erfassungswerte nach der Unterbrechung zu einer falschen Detektion der Aktivierungshandlung führen. Bspw. können durch die Annäherung die Erfassungswerte erhöht werden, und nach der Unterbrechung ggf. zu hoch sein, sodass bereits eine geringfügige Annäherung zur Detektion der Aktivierungshandlung führen kann. Daher ist es vorteilhaft, zusätzlich zur Unterbrechung mittels einer Neuinitialisierung vergangene (historische) Messwerte zu löschen.

Des Weiteren kann vorgesehen sein, dass die Überwachungsanordnung eine (insbesondere elektronische) Verarbeitungsvorrichtung, wie einen Mikrocontroller oder Prozessor oder integrierten Schaltkreis oder dergleichen, insbesondere die Verarbeitungsvorrichtung der Sensoranordnung, aufweist, vorzugsweise um die Neuinitialisierung zur Rekalibrierung der Sensoranordnung (insbesondere zusätzlich und/oder in Abhängigkeit von der Unterbrechung) durchzuführen. Damit kann eine aus der vorangegangenen Annäherung und/oder auch der Annäherung während der Unterbrechung resultierende Fehldetektion der Aktivierungshandlung verhindert werden.

Auch ist es optional denkbar, dass die Überwachungsanordnung eine (insbesondere elektronische) Schnittstellenvorrichtung aufweist, um über die Schnittstellenvorrichtung eine Kommunikationsinformation über die Kommunikation zu erhalten, und um in Abhängigkeit von der Kommunikationsinformation die Unterbrechung und/oder Neuinitialisierung zu initiieren. Die Schnittstellenvorrichtung kann dazu genutzt werden, um festzustellen, ob die Kommunikation stattfindet. Bspw. weist die Kommunikationsinformation auf eine erfolgreich initiierte Kommunikation mit dem mobilen Gerät hin. Sobald die Detektion der Aktivierungshandlung zur erfolgreichen Aufnahme der Kommunikation geführt hat, kann vorübergehend auf die kapazitive Erfassung während der Unterbrechung verzichtet werden.

Es kann von Vorteil sein, wenn im Rahmen der Erfindung eine Kontrollvorrichtung vorgesehen ist, um in Abhängigkeit von der Kommunikation eine Funktionsaktivierung beim Fahrzeug durchzuführen. Ferner kann die Überwachungsanordnung dadurch zur Initiierung der Unterbrechung und/oder Neuinitialisierung der kapazitiven Erfassung in Abhängigkeit von der Kommunikation ausgeführt sein, dass die Überwachungsanordnung eine Schnittstellenvorrichtung zur Detektion der Funktionsaktivierung aufweist, um in Abhängigkeit von der Funktionsaktivierung die Unterbrechung und/oder Neuinitialisierung zu initiieren. Die Kontrollvorrichtung kann bspw. ein Teil der Kommunikationsanordnung oder eines Steuergeräts des Fahrzeuges sein. Die Kontrollvorrichtung kann z. B. durch die Kommunikation eine Authentifizierung des mobilen Geräts durchführen, z. B. durch die Auswertung eines Codes, welcher über die Kommunikation übertragen wird. Weiter kann die Kontrollvorrichtung bei erfolgreicher Authentifizierung die Fahrzeugfunktion z. B. dadurch aktivieren, dass bei der Funktionsaktivierung ein Schließsystem des Fahrzeuges angesteuert wird. Wenn die Funktionsaktivierung erfolgreich ist, kann dies über die Schnittstellenvorrichtung erkannt werden und die kapazitive Erfassung vorübergehend ausgesetzt werden. Hierzu kann die Schnittstellenvorrichtung z. B. einen Eingang aufweisen, welcher von der Kontrollvorrichtung zur Informationsübertragung genutzt wird, um die Funktionsaktivierung mitzuteilen.

Vorzugsweise kann vorgesehen sein, dass eine (insbesondere elektronische) Schnittstellenvorrichtung der Überwachungsanordnung vorgesehen ist, um eine Kommunikationsinformation über die Kommunikation zu erhalten, insbesondere über eine Initiierung der Kommunikation oder einen Abschluss der Kommunikation oder wenigstens eine über die Kommunikation übertragene Information oder ein Ergebnis der Kommunikation, insbesondere ein Authentifizierungsergebnis, oder ein Ergebnis einer Funktionsaktivierung durch die Kommunikation beim Fahrzeug. Somit kann es möglich sein, dass ein Empfang dieser Kommunikationsinformation durch die Schnittstellenvorrichtung dazu führt, dass die Unterbrechung und/oder Neuinitialisierung initiiert wird.

Ebenfalls Gegenstand der Erfindung ist ein Verfahren zur Detektion einer Aktivierungshandlung in einem Aktivierungsbereich für ein Fahrzeug.

Hierbei ist vorgesehen, dass die nachfolgenden Schritte durchgeführt werden, vorzugsweise nacheinander oder in beliebiger Reihenfolge, wobei die Schritte auch wiederholt durchgeführt werden können:
- Durchführen einer (insbesondere wiederholten) kapazitiven Erfassung einer Annäherung zumindest teilweise im Aktivierungsbereich (d. h. in zumindest einem Teilbereich des Aktivierungsbereichs, vorzugsweise einem Erfassungsbereich), um die Aktivierungshandlung zu detektieren,
- Durchführen einer Kommunikation zumindest teilweise im Aktivierungsbereich (d. h. in zumindest einem Teilbereich des Aktivierungsbereichs, vorzugsweise einem Kommunikationsbereich),
- Durchführen einer Initiierung einer Unterbrechung und/oder Neuinitialisierung der kapazitiven Erfassung in Abhängigkeit von der Kommunikation.

Damit bringt das erfindungsgemäße Verfahren die gleichen Vorteile mit sich, wie sie ausführlich mit Bezug auf ein erfindungsgemäßes System beschrieben worden sind. Zudem ist im Rahmen der Erfindung denkbar, dass die Verfahrensschritte durch ein erfindungsgemäßes System ausgeführt werden.

Vorteilhaft ist es zudem, wenn die kapazitive Erfassung in einem Erfassungsbereich des Aktivierungsbereichs und die Kommunikation in einem Kommunikationsbereich des Aktivierungsbereichs durchgeführt werden, wobei insbesondere der Erfassungsbereich und der Kommunikationsbereich teilweise überlappen, vorzugsweise um in Abhängigkeit von der Detektion der Aktivierungshandlung die Kommunikation zu initiieren. Somit ist es möglich, die Kommunikation solange deaktiviert zu lassen und/oder die Kommunikationsanordnung solange in einem Energiesparmodus zu halten, bis die Aktivierungshandlung detektiert wird. Alternativ kann die Kommunikation auch unabhängig von der Detektion der Aktivierungshandlung, z. B. durchgehend, durchgeführt werden.

Des Weiteren ist es im Rahmen der Erfindung optional möglich, dass mittels der Kommunikation eine Authentifizierung durchgeführt wird, um eine sicherheitsrelevante Funktion des Fahrzeuges zu aktivieren, wobei die Unterbrechung in Abhängigkeit von der Funktionsaktivierung initiiert werden kann, wobei vorzugsweise die sicherheitsrelevante Funktion eine Entriegelung einer Tür des Fahrzeuges umfasst. Entsprechend kann das System auch in einen Türgriff für das Fahrzeug integriert sein, um eine Annäherung an den Türgriff als Aktivierungshandlung zu detektieren.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Es zeigen:
- Fig. 1: eine schematische Seiten- und Draufsicht auf ein Fahrzeug mit einem erfindungsgemäßen System,
- Fig. 2: eine schematische Darstellung von Teilen eines erfindungsgemäßen Systems,
- Fig. 3: eine schematische Darstellung zur Visualisierung eines erfindungsgemäßen Verfahrens.

In den nachfolgenden Figuren werden für die gleichen technischen Merkmale auch von unterschiedlichen Ausführungsbeispielen die identischen Bezugszeichen verwendet.

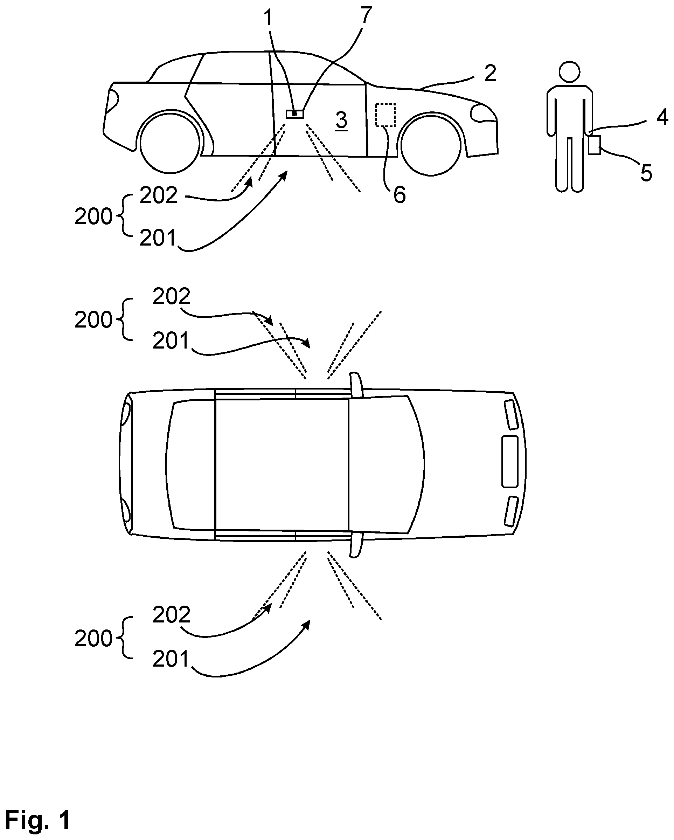

In Figur 1 ist ein erfindungsgemäßes System 1 zur Detektion einer Aktivierungshandlung in einem Aktivierungsbereich 200 für ein Fahrzeug 2 dargestellt, welches beispielhaft in einen Türgriff 7 des Fahrzeuges 2 integriert ist. Der Aktivierungsbereich 200 weist vorteilhafterweise einen Erfassungsbereich 201 und einen Kommunikationsbereich 202 auf, welche zumindest teilweise überlappen können. Dabei kann es vorgesehen sein, dass ein Aktivierungsmittel 4 wie eine Hand 4 eines Benutzers ein mobiles Gerät 5 wie ein Smartphone zur Authentifizierung in den Aktivierungsbereich 200 einbringt. Dies kann dazu dienen, eine Funktionsaktivierung 220 bei dem Fahrzeug 2 durchzuführen, z. B. eine Entriegelung und/oder Öffnung der Tür 3 des Fahrzeuges 2. Eine Kontrollvorrichtung 6 kann am Fahrzeug 2 vorgesehen sein, um in Abhängigkeit von einer Kommunikation 240 mit dem mobilen Gerät 5, bspw. der Authentifizierung, die Funktionsaktivierung 220 beim Fahrzeug 2 durchzuführen. Um dies zu ermöglichen, kann ein erfindungsgemäßes System 1 dazu ausgebildet sein, sowohl das Einbringen des mobilen Geräts 5 als Aktivierungshandlung zu detektieren, als auch die Kommunikation für die Authentifizierung bereitzustellen.

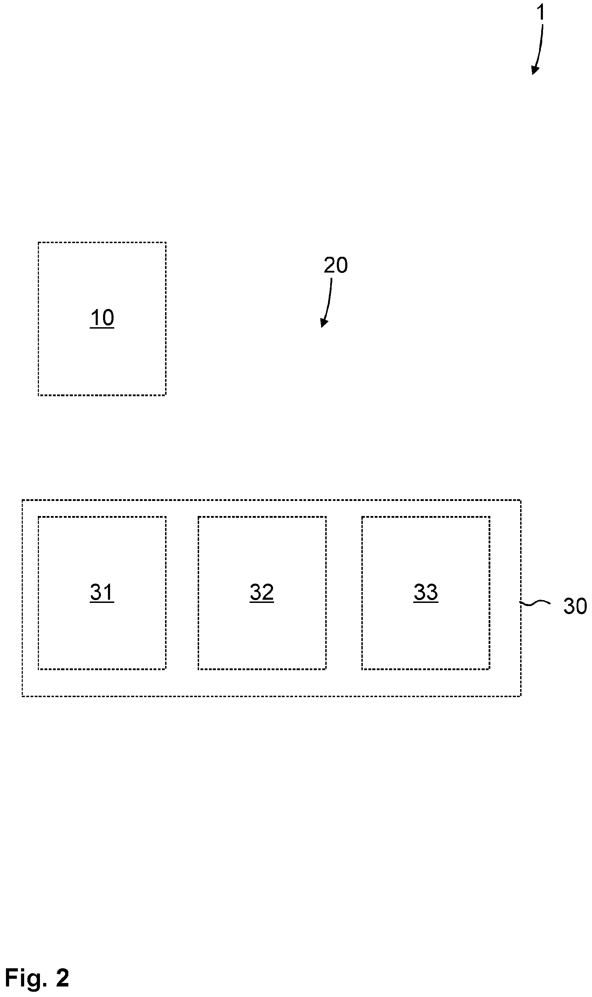

In Figur 2 ist ein erfindungsgemäßes System 1 schematisch mit weiteren Einzelheiten dargestellt. Das System 1 kann eine Sensoranordnung 30 zur kapazitiven Erfassung 250 einer Annäherung z. B. des Aktivierungsmittels 4 mit dem mobilen Gerät 5 an das Fahrzeug 2 aufweisen. Diese Erfassung 250 kann zumindest teilweise im Aktivierungsbereich 200 stattfinden, d. h. in zumindest einem Teil des Aktivierungsbereichs 200, also vorzugsweise im Erfassungsbereich 201, um die Aktivierungshandlung zu detektieren.

Weiter kann eine Kommunikationsanordnung 10 zur Durchführung einer Kommunikation 240 für das Fahrzeug 2 vorgesehen sein, wobei auch hier die Kommunikation zumindest teilweise im Aktivierungsbereich 200 durchgeführt wird, insbesondere in dem Kommunikationsbereich 202 des Aktivierungsbereichs 200.

Ferner ist eine Überwachungsanordnung 20 zur Initiierung einer Unterbrechung 230 und/oder Neuinitialisierung 210 der kapazitiven Erfassung 250 in Abhängigkeit von der Kommunikation 240 vorgesehen. Damit kann nach der Kommunikation eine weitere Detektion bzw. eine Fehldetektion der Aktivierungshandlung verhindert werden.

Anhand Figur 1 wird zudem deutlich, dass die Kommunikationsanordnung 10 - bspw. in der Form einer Nahfeld-Kommunikationsanordnung zur Kommunikation 240 in der Form einer Nahfeldkommunikation - dazu ausgebildet ist, die Kommunikation 240 begrenzt auf zumindest einen Kommunikationsbereich 202 des Aktivierungsbereichs 200 durchzuführen. Dadurch kann die Kommunikationsanordnung 10 dazu dienen, die Kommunikation 240 mit dem mobilen Gerät 5 (erst) dann initial durchzuführen, wenn das mobile Gerät 5 in den Kommunikationsbereich 202 des Aktivierungsbereichs 200 eingebracht wird, wobei die Annäherung bei der Aktivierungshandlung für das Einbringen des mobilen Geräts 5 spezifisch ist.

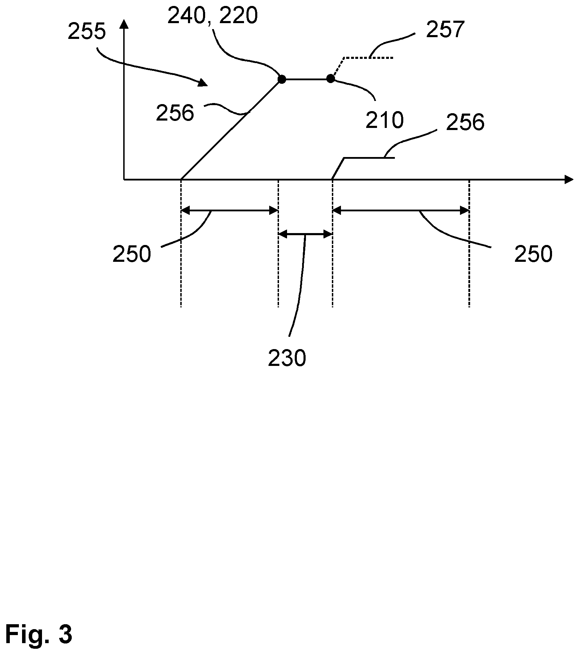

Die Sensoranordnung 30 kann eine Speichervorrichtung 33 aufweisen, um einen zeitlichen Verlauf von Erfassungswerten 255 der kapazitiven Erfassung 250 für die Detektion der Aktivierungshandlung zu speichern, und eine Verarbeitungsvorrichtung 32 aufweist, um bei der Neuinitialisierung 210 die Speicherung der Erfassungswerte aufzuheben und insbesondere die Erfassungswerte zu löschen. Ein beispielhafter zeitlicher Verlauf von Erfassungswerten 255 ist zudem in Figur 3 dargestellt. Dieser zeitliche Verlauf kann dazu dienen, die Aktivierungshandlung zu detektieren, wobei eine Verarbeitungsvorrichtung 32 der Sensoranordnung 30 dazu ausgeführt sein kann, zur Detektion der Aktivierungshandlung den bereitgestellten Verlauf auszuwerten, und insbesondere nach einem Anstieg der Erfassungswerte 255 die Erfassungswerte 255 mit einem Schwellenwert zu vergleichen, und bei der Neuinitialisierung 210 den bereitgestellten Verlauf zurückzusetzen.

Ferner kann die Überwachungsanordnung 20 eine Schnittstellenvorrichtung 31 aufweist, um über die Schnittstellenvorrichtung 31 eine Kommunikationsinformation über die Kommunikation 240 zu erhalten, und um in Abhängigkeit von der Kommunikationsinformation die Unterbrechung 230 zu initiieren.

In Figur 3 wird schematisch ein erfindungsgemäßes Verfahren visualisiert. Es ist erkennbar, dass zunächst durch eine wiederholte kapazitive Erfassung 250 ein Verlauf von Erfassungswerten 255 ermittelt und gespeichert werden kann. Dabei ist ein erster Verlauf 256 dargestellt, welcher während der Annäherung erfasst wird. Nachdem der Anstieg eine bestimmte Schwelle erreicht hat, erfolgt die Kommunikation 240 und Funktionsaktivierung 220. Daraufhin wird eine Unterbrechung 230 der Erfassung 250 durchgeführt, wobei optional auch eine Neuinitialisierung 210 stattfinden kann. Somit erfolgt ein Durchführen einer Initiierung der Unterbrechung 230 und/oder der Neuinitialisierung 210 der kapazitiven Erfassung 250 in Abhängigkeit von der Kommunikation 240. Würde die Neuinitialisierung 210 nicht erfolgen, könnte im vorliegenden Beispiel der Verlauf der Erfassungswerte 255 weiter ansteigen und ggf. zur Fehldetektion führen (siehe gestrichelte Linie des zweiten Verlaufs 257).

Die voranstehende Erläuterung der Ausführungsformen beschreibt die vorliegende Erfindung ausschließlich im Rahmen von Beispielen. Selbstverständlich können einzelne Merkmale der Ausführungsformen, sofern technisch sinnvoll, frei miteinander kombiniert werden, ohne den Rahmen der vorliegenden Erfindung zu verlassen.

### Bezugszeichenliste

- 1: System
- 2: Fahrzeug
- 3: Tür
- 4: Aktivierungsmittel, Hand
- 5: Gerät
- 6: Kontrollvorrichtung
- 7: Türgriff

- 10: Kommunikationsanordnung

- 20: Überwachungsanordnung

- 30: Sensoranordnung
- 31: Schnittstellenvorrichtung
- 32: Verarbeitungsvorrichtung
- 33: Speichervorrichtung

- 200: Aktivierungsbereich
- 201: Erfassungsbereich
- 202: Kommunikationsbereich
- 210: Neuinitialisierung

- 220: Funktionsaktivierung
- 230: Unterbrechung

- 240: Kommunikation
- 250: Erfassung
- 255: Erfassungswerte
- 256: erster Verlauf
- 257: zweiter Verlauf

## Patentansprüche

1. System (1) zur Detektion einer Aktivierungshandlung in einem Aktivierungsbereich (200) für ein Fahrzeug (2), aufweisend:
- eine Sensoranordnung (30) zur kapazitiven Erfassung (250) einer Annäherung zumindest teilweise im Aktivierungsbereich (200), um die Aktivierungshandlung zu detektieren,
- eine Kommunikationsanordnung (10) zur Durchführung einer Kommunikation (240) zumindest teilweise im Aktivierungsbereich (200),
- eine Überwachungsanordnung (20) zur Initiierung einer Unterbrechung (230) und/oder Neuinitialisierung (210) der kapazitiven Erfassung (250) in Abhängigkeit von der Kommunikation (240).

2. System (1) nach Anspruch 1,
**dadurch gekennzeichnet,**
**dass** die Kommunikationsanordnung (10) als eine Nahfeld-Kommunikationsanordnung ausgebildet ist, um die Kommunikation (240) in der Form einer Nahfeldkommunikation begrenzt auf zumindest einen Kommunikationsbereich (202) des Aktivierungsbereichs (200) durchzuführen.

3. System (1) nach Anspruch 1 oder 2,
**dadurch gekennzeichnet,**
**dass** die Kommunikationsanordnung (10) dazu ausgeführt ist, die Kommunikation (240) mit einem mobilen Gerät (5) dann initial durchzuführen, wenn das mobile Gerät (5) in einen Kommunikationsbereich (202) des Aktivierungsbereichs (200) eingebracht wird, wobei die Annäherung bei der Aktivierungshandlung für das Einbringen des mobilen Geräts (5) spezifisch ist.

4. System (1) nach einem der vorhergehenden Ansprüche,
**dadurch gekennzeichnet,**
**dass** die Überwachungsanordnung (20) dazu ausgeführt ist, in Abhängigkeit von der Unterbrechung (230), insbesondere nach und/oder bei und/oder vor der Unterbrechung (230) und/oder vor einer Wiederaufnahme der kapazitiven Erfassung (250) nach der Unterbrechung (230), die Neuinitialisierung (210) bei der Sensoranordnung (30) zu initiieren.

5. System (1) nach einem der vorhergehenden Ansprüche,
**dadurch gekennzeichnet,**
**dass** die Sensoranordnung (30) eine Speichervorrichtung (33) aufweist, um einen zeitlichen Verlauf von Erfassungswerten (255) der kapazitiven Erfassung (250) für die Detektion der Aktivierungshandlung zu speichern, und eine Verarbeitungsvorrichtung (32) aufweist, um bei der Neuinitialisierung (210) die Speicherung der Erfassungswerte aufzuheben.

6. System (1) nach einem der vorhergehenden Ansprüche,
**dadurch gekennzeichnet,**
**dass** die Sensoranordnung (30) dazu ausgeführt ist, nach der Neuinitialisierung (210) wiederholt die Erfassungen (250) bis zur Unterbrechung (230) durchzuführen, um wiederholt die Aktivierungshandlung zu detektieren.

7. System (1) nach einem der vorhergehenden Ansprüche,
**dadurch gekennzeichnet,**
**dass** die Sensoranordnung (30) dazu ausgeführt ist, einen zeitlichen Verlauf von Erfassungswerten (255) der kapazitiven Erfassung (250) für die Detektion der Aktivierungshandlung bereitzustellen, wobei eine Verarbeitungsvorrichtung (32) der Sensoranordnung (30) dazu ausgeführt ist, zur Detektion der Aktivierungshandlung den bereitgestellten Verlauf auszuwerten, insbesondere nach einem Anstieg der Erfassungswerte (255) die Erfassungswerte (255) mit einem Schwellenwert zu vergleichen, und bei der Neuinitialisierung (210) den bereitgestellten Verlauf zurückzusetzen.

8. System (1) nach einem der vorhergehenden Ansprüche,
**dadurch gekennzeichnet,**
**dass** die Überwachungsanordnung (20) eine Verarbeitungsvorrichtung (32) aufweist, um die Neuinitialisierung (210) zur Rekalibrierung der Sensoranordnung (30) durchzuführen.

9. System (1) nach einem der vorhergehenden Ansprüche,
**dadurch gekennzeichnet,**
**dass** die Überwachungsanordnung (20) eine Schnittstellenvorrichtung (31) aufweist, um über die Schnittstellenvorrichtung (31) eine Kommunikationsinformation über die Kommunikation (240) zu erhalten, und um in Abhängigkeit von der Kommunikationsinformation die Unterbrechung (230) und/oder Neuinitialisierung (210) zu initiieren.

10. System (1) nach einem der vorhergehenden Ansprüche,
**dadurch gekennzeichnet,**
**dass** eine Kontrollvorrichtung (6) vorgesehen ist, um in Abhängigkeit von der Kommunikation (240) eine Funktionsaktivierung (220) beim Fahrzeug (2) durchzuführen, wobei die Überwachungsanordnung (20) dadurch zur Initiierung der Unterbrechung (230) und/oder Neuinitialisierung (210) der kapazitiven Erfassung (250) in Abhängigkeit von der Kommunikation (240) ausgeführt ist, dass die Überwachungsanordnung (20) eine Schnittstellenvorrichtung (31) zur Detektion der Funktionsaktivierung (220) aufweist, um in Abhängigkeit von der Funktionsaktivierung (220) die Unterbrechung (230) und/oder Neuinitialisierung (210) zu initiieren.

11. System (1) nach einem der vorhergehenden Ansprüche,
**dadurch gekennzeichnet,**
**dass** eine Schnittstellenvorrichtung (31) der Überwachungsanordnung (20) vorgesehen ist, um eine Kommunikationsinformation über die Kommunikation (240) zu erhalten, insbesondere über eine Initiierung der Kommunikation (240) oder einen Abschluss der Kommunikation (240) oder wenigstens eine über die Kommunikation (240) übertragene Information oder ein Ergebnis der Kommunikation (240), insbesondere ein Authentifizierungsergebnis, oder ein Ergebnis einer Funktionsaktivierung (220) durch die Kommunikation (240) beim Fahrzeug (2).

12. Verfahren zur Detektion einer Aktivierungshandlung in einem Aktivierungsbereich (200) für ein Fahrzeug (2), wobei die nachfolgenden Schritte durchgeführt werden:
- Durchführen einer wiederholten kapazitiven Erfassung (250) einer Annäherung zumindest teilweise im Aktivierungsbereich (200), um die Aktivierungshandlung zu detektieren,
- Durchführen einer Kommunikation (240) zumindest teilweise im Aktivierungsbereich (200),
- Durchführen einer Initiierung einer Unterbrechung (230) und/oder Neuinitialisierung (210) der kapazitiven Erfassung (250) in Abhängigkeit von der Kommunikation (240).

13. Verfahren (1) nach einem der vorhergehenden Ansprüche,
**dadurch gekennzeichnet,**
**dass** die kapazitive Erfassung (250) in einem Erfassungsbereich (201) des Aktivierungsbereichs (200) und die Kommunikation (240) in einem Kommunikationsbereich (202) des Aktivierungsbereichs (200) durchgeführt werden, um in Abhängigkeit von der Detektion der Aktivierungshandlung die Kommunikation (240) zu initiieren.

14. Verfahren (1) nach einem der vorhergehenden Ansprüche,
**dadurch gekennzeichnet,**
**dass** mittels der Kommunikation (240) eine Authentifizierung durchgeführt wird, um eine sicherheitsrelevante Funktion des Fahrzeuges (2) zu aktivieren, wobei die Unterbrechung (230) und/oder Neuinitialisierung (210) in Abhängigkeit von der Funktionsaktivierung (220) initiiert wird, wobei die sicherheitsrelevante Funktion eine Entriegelung einer Tür (3) des Fahrzeuges (2) umfasst.

15. Verfahren (1) nach einem der vorhergehenden Ansprüche,
**dadurch gekennzeichnet,**
**dass** die Verfahrensschritte durch ein System (1) nach einem der vorhergehenden Ansprüche ausgeführt werden.

## Claims

1. A system (1) for detecting an activation action in an activation region (200) for a vehicle (2), comprising:
- a sensor arrangement (30) for capacitively detecting (250) an approach at least partially in the activation region (200) in order to detect the activation action,
- a communication arrangement (10) for carrying out a communication (240) at least partially in the activation region (200),
- a monitoring arrangement (20) for initiating an interruption (230) and/or reinitialization (210) of the capacitive detection (250) in dependence on the communication (240).

2. The system (1) according to claim 1,
**characterized in that**
the communication arrangement (10) is configured as a near-field communication arrangement in order to carry out the communication (240) in the form of a near-field communication limited to at least one communication region (202) of the activation region (200).

3. The system (1) according to claim 1 or 2,
**characterized in that**
the communication arrangement (10) is configured to carry out the communication (240) with a mobile device (5) initially when the mobile device (5) is introduced into a communication region (202) of the activation region (200), wherein the approach in the activation action is specific to the introduction of the mobile device (5).

4. The system (1) according to any one of the preceding claims,
**characterized in that**
the monitoring arrangement (20) is configured to initiate the reinitialization (210) at the sensor arrangement (30) in dependence on the interruption (230), in particular after and/or during and/or before the interruption (230) and/or before a resumption of the capacitive detection (250) after the interruption (230).

5. The system (1) according to any one of the preceding claims,
**characterized in that**
the sensor arrangement (30) has a memory device (33) in order to store a temporal course of detection values (255) of the capacitive detection (250) for the detection of the activation action, and has a processing device (32) in order to cancel the storage of the detection values upon the reinitialization (210).

6. The system (1) according to any one of the preceding claims,
**characterized in that**
the sensor arrangement (30) is configured to repeatedly carry out the detections (250) after the reinitialization (210) until the interruption (230), in order to repeatedly detect the activation action.

7. The system (1) according to any one of the preceding claims,
**characterized in that**
the sensor arrangement (30) is configured to provide a temporal course of detection values (255) of the capacitive detection (250) for the detection of the activation action, wherein a processing device (32) of the sensor arrangement (30) is configured to evaluate the provided course for the detection of the activation action, in particular to compare the detection values (255) with a threshold value after a rise of the detection values (255), and to reset the provided course upon the reinitialization (210).

8. The system (1) according to any one of the preceding claims,
**characterized in that**
the monitoring arrangement (20) has a processing device (32) in order to carry out the reinitialization (210) for recalibrating the sensor arrangement (30).

9. The system (1) according to any one of the preceding claims,
**characterized in that**
the monitoring arrangement (20) has an interface device (31) in order to obtain, via the interface device (31), communication information about the communication (240), and in order to initiate the interruption (230) and/or reinitialization (210) in dependence on the communication information.

10. The system (1) according to any one of the preceding claims,
**characterized in that**
a control device (6) is provided in order to carry out a function activation (220) at the vehicle (2) in dependence on the communication (240), wherein the monitoring arrangement (20) is configured to initiate the interruption (230) and/or reinitialization (210) of the capacitive detection (250) in dependence on the communication (240) **in that** the monitoring arrangement (20) has an interface device (31) for detecting the function activation (220), in order to initiate the interruption (230) and/or reinitialization (210) in dependence on the function activation (220).

11. The system (1) according to any one of the preceding claims,
**characterized in that**
an interface device (31) of the monitoring arrangement (20) is provided in order to obtain communication information about the communication (240), in particular about an initiation of the communication (240) or a completion of the communication (240) or at least one piece of information transmitted via the communication (240) or a result of the communication (240), in particular an authentication result, or a result of a function activation (220) at the vehicle (2) through the communication (240).

12. A method for detecting an activation action in an activation region (200) for a vehicle (2), wherein the following steps are carried out:
- carrying out a repeated capacitive detection (250) of an approach at least partially in the activation region (200) in order to detect the activation action,
- carrying out a communication (240) at least partially in the activation region (200),
- carrying out an initiation of an interruption (230) and/or reinitialization (210) of the capacitive detection (250) in dependence on the communication (240).

13. The method (1) according to any one of the preceding claims,
**characterized in that**
the capacitive detection (250) is carried out in a detection region (201) of the activation region (200) and the communication (240) is carried out in a communication region (202) of the activation region (200), in order to initiate the communication (240) in dependence on the detection of the activation action.

14. The method (1) according to any one of the preceding claims,
**characterized in that**
an authentication is carried out through the communication (240) in order to activate a safety-relevant function of the vehicle (2), wherein the interruption (230) and/or reinitialization (210) is initiated in dependence on the function activation (220), wherein the safety-relevant function comprises an unlocking of a door (3) of the vehicle (2).

15. The method (1) according to any one of the preceding claims,
**characterized in that**
the method steps are carried out by a system (1) according to any one of the preceding claims.

## Revendications

1. Système (1) pour la détection d'une action d'activation dans une zone d'activation (200) pour un véhicule (2), comprenant :
- un agencement de capteurs (30) pour la détection capacitive (250) d'une approche au moins partiellement dans la zone d'activation (200), afin de détecter l'action d'activation,
- un agencement de communication (10) pour la réalisation d'une communication (240) au moins partiellement dans la zone d'activation (200),
- un agencement de surveillance (20) pour l'initiation d'une interruption (230) et/ou d'une réinitialisation (210) de la détection capacitive (250) en fonction de la communication (240).

2. Système (1) selon la revendication 1,
**caractérisé en ce que**
l'agencement de communication (10) est configuré comme un agencement de communication en champ proche, afin de réaliser la communication (240) sous la forme d'une communication en champ proche limitée à au moins une zone de communication (202) de la zone d'activation (200).

3. Système (1) selon la revendication 1 ou 2,
**caractérisé en ce que**
l'agencement de communication (10) est configuré pour réaliser la communication (240) avec un dispositif mobile (5) initialement lorsque le dispositif mobile (5) est introduit dans une zone de communication (202) de la zone d'activation (200), l'approche lors de l'action d'activation étant spécifique à l'introduction du dispositif mobile (5).

4. Système (1) selon l'une quelconque des revendications précédentes,
**caractérisé en ce que**
l'agencement de surveillance (20) est configuré pour initier la réinitialisation (210) au niveau de l'agencement de capteurs (30) en fonction de l'interruption (230), en particulier après et/ou pendant et/ou avant l'interruption (230) et/ou avant une reprise de la détection capacitive (250) après l'interruption (230).

5. Système (1) selon l'une quelconque des revendications précédentes,
**caractérisé en ce que**
l'agencement de capteurs (30) présente un dispositif de mémoire (33) afin de mémoriser une évolution temporelle de valeurs de détection (255) de la détection capacitive (250) pour la détection de l'action d'activation, et présente un dispositif de traitement (32) afin de supprimer, lors de la réinitialisation (210), la mémorisation des valeurs de détection.

6. Système (1) selon l'une quelconque des revendications précédentes,
**caractérisé en ce que**
l'agencement de capteurs (30) est configuré pour réaliser de manière répétée les détections (250) après la réinitialisation (210) jusqu'à l'interruption (230), afin de détecter de manière répétée l'action d'activation.

7. Système (1) selon l'une quelconque des revendications précédentes,
**caractérisé en ce que**
l'agencement de capteurs (30) est configuré pour fournir une évolution temporelle de valeurs de détection (255) de la détection capacitive (250) pour la détection de l'action d'activation, un dispositif de traitement (32) de l'agencement de capteurs (30) étant configuré pour évaluer, pour la détection de l'action d'activation, l'évolution fournie, en particulier pour comparer, après une augmentation des valeurs de détection (255), les valeurs de détection (255) à une valeur seuil, et pour réinitialiser l'évolution fournie lors de la réinitialisation (210).

8. Système (1) selon l'une quelconque des revendications précédentes,
**caractérisé en ce que**
l'agencement de surveillance (20) présente un dispositif de traitement (32) afin de réaliser la réinitialisation (210) pour le recalibrage de l'agencement de capteurs (30).

9. Système (1) selon l'une quelconque des revendications précédentes,
**caractérisé en ce que**
l'agencement de surveillance (20) présente un dispositif d'interface (31) afin d'obtenir, par l'intermédiaire du dispositif d'interface (31), une information de communication concernant la communication (240), et afin d'initier l'interruption (230) et/ou la réinitialisation (210) en fonction de l'information de communication.

10. Système (1) selon l'une quelconque des revendications précédentes,
**caractérisé en ce que**
un dispositif de contrôle (6) est prévu afin de réaliser, en fonction de la communication (240), une activation de fonction (220) au niveau du véhicule (2), l'agencement de surveillance (20) étant configuré pour l'initiation de l'interruption (230) et/ou de la réinitialisation (210) de la détection capacitive (250) en fonction de la communication (240) **en ce que** l'agencement de surveillance (20) présente un dispositif d'interface (31) pour la détection de l'activation de fonction (220), afin d'initier, en fonction de l'activation de fonction (220), l'interruption (230) et/ou la réinitialisation (210).

11. Système (1) selon l'une quelconque des revendications précédentes,
**caractérisé en ce que**
un dispositif d'interface (31) de l'agencement de surveillance (20) est prévu afin d'obtenir une information de communication concernant la communication (240), en particulier concernant une initiation de la communication (240) ou un achèvement de la communication (240) ou au moins une information transmise par l'intermédiaire de la communication (240) ou un résultat de la communication (240), en particulier un résultat d'authentification, ou un résultat d'une activation de fonction (220) par la communication (240) au niveau du véhicule (2).

12. Procédé pour la détection d'une action d'activation dans une zone d'activation (200) pour un véhicule (2), les étapes suivantes étant réalisées :
- réalisation d'une détection capacitive répétée (250) d'une approche au moins partiellement dans la zone d'activation (200), afin de détecter l'action d'activation,
- réalisation d'une communication (240) au moins partiellement dans la zone d'activation (200),
- réalisation d'une initiation d'une interruption (230) et/ou d'une réinitialisation (210) de la détection capacitive (250) en fonction de la communication (240).

13. Procédé (1) selon l'une quelconque des revendications précédentes,
**caractérisé en ce que**
la détection capacitive (250) est réalisée dans une zone de détection (201) de la zone d'activation (200) et la communication (240) est réalisée dans une zone de communication (202) de la zone d'activation (200), afin d'initier la communication (240) en fonction de la détection de l'action d'activation.

14. Procédé (1) selon l'une quelconque des revendications précédentes,
**caractérisé en ce que**
une authentification est réalisée au moyen de la communication (240) afin d'activer une fonction relative à la sécurité du véhicule (2), l'interruption (230) et/ou la réinitialisation (210) étant initiée en fonction de l'activation de fonction (220), la fonction relative à la sécurité comprenant un déverrouillage d'une porte (3) du véhicule (2).

15. Procédé (1) selon l'une quelconque des revendications précédentes,
**caractérisé en ce que**
les étapes du procédé sont réalisées par un système (1) selon l'une quelconque des revendications précédentes.
